# EUROPÄISCHE PATENTSCHRIFT

(11) **EP 1 001 295 B1**
(45) Veröffentlichungstag und Bekanntmachung des Hinweises auf die Patenterteilung: **13.08.2003**
(21) Anmeldenummer: 99121104.6
(22) Anmeldetag: 22.10.1999
(51) Int. Cl.: G02B 17/08, G03F 7/20

(54) **Polarisationsoptisch kompensiertes Objektiv**
Objective with polarisation effects compensation
Objectif avec compensation d'effets polarisants

(30) Priorität: 10.11.1998 DE 19851749
(43) Veröffentlichungstag der Anmeldung: 17.05.2000
(73) Patentinhaber: Carl Zeiss, 89518 Heidenheim (Brenz) (DE); Carl-Zeiss-Stiftung trading as Carl Zeiss, 89518 Heidenheim (Brenz) (DE)
(72) Erfinder: Schuster, Karl-Heinz, 89551 Königsbronn (DE)

(56) Entgegenhaltungen:
- EP-A- 0 736 789
- EP-A- 0 834 753
- EP-A- 0 937 999
- DE-A- 4 110 296
- DE-A- 19 535 392
- US-A- 5 253 110
- US-A- 5 475 491

## Beschreibung

Zur Belichtung von Mikrostrukturen mit hoher Auflösung in Resists sind hohe numerische Aperturen (z.B. 0,6-0,8) vorteilhaft.

Dabei ist es dann zur Vermeidung störender Reflexionen und anderer Störungen erforderlich, daß die Polarisation der Lichtstrahlen bezüglich der optischen Achse rotationssymmetrisch ist. Geeignet sind also radiale Polarisation (vgl. DE 195 35 392) - und auch zirkulare Polarisation, sowie unpolarisiertes Licht.

Linear polarisiertes Licht wird generell als ungeeignet angesehen, da es richtungsabhängige Effekte bewirkt. Ausnahmen sehen die gezielte Anpassung der Polarisationsrichtung an die Strukturrichtung vor.

Umlenkspiegel zeigen für in der Einfallsebene polarisiertes und senkrecht dazu polarisiertes Licht einen Versatz des austretenden Lichtstrahls und Phasenverschiebungen durch unterschiedliche Wechselwirkung des elektromagnetischen Feldes mit der spiegelnden Grenzfläche.

Katadioptrische Projektionsobjektive mit Strahlteiler vom Typ der DE 196 39 586 A (US Serial No. 08/936,537, 09/263,788) und darin angegebener Zitate haben dies Problem nicht, da ohnehin wegen des Polarisationsstrahlteilers linear polarisiertes Licht verwendet werden muß (und erst danach die Polarisation z.B. mit einer Lambdaviertelplatte geändert werden kann).

Anders ist das beispielsweise bei den katadioptrischen Projektionsobjektiven vom Typ des abgewandelten Schupmann-Achromaten u.a. nach EP 0 736 789 A2.

Beispielsweise zeigt EP 0 736 789 A2 in Figur 6 und 9 je zwei Umlenkspiegel (M₀, M₂; M₂, M₃), wobei einer (M₂; M₂) zur Separation der zu dem Konkavspiegel (M₁) gehenden und davon zurücklaufenden Lichtbündel dient und der andere (M₀; M₃) die Parallellage von Reticle und Wafer ermöglicht. Werden diese Spiegel mit einer Mischung von in der Einfallsebene und senkrecht dazu polarisiertem Licht - also z.B. mit unpolarisiertem, zirkular oder elliptisch polarisiertem bder radial polarisiertem - beleuchtet, so ergibt die Umlenkung um rund 90° jeweils einen Seitenversatz der den beiden Polarisationsrichtungen zugeordneten Strahlanteile, der sich bei beiden Spiegeln additiv auswirkt. Folge davon sind Gangunterschiede und Lageverschiebungen der das Bild am Wafer erzeugenden Strahlenbündel und damit eine Verschlechterung des Bildes.

Der Effekt ist zwar klein, spielt aber bei den Auflösungen im Bereich unter 0,5 µm und den Wellenlängen im DUV, für den derartige katadioptrische Projektionsobjektive vorgesehen sind, schon eine störende Rolle.

Auch am Konkavspiegel tritt der Effekt prinzipiell auf, wegen der wesentlich kleineren Umlenkwinkel bleibt er aber sehr klein.

Aufgabe der Erfindung ist es, die Abbildungsqualität eines Objektivs mit Umlenkspiegel unabhängig von den Polarisationseigenschaften des Lichts zu machen, insbesondere rotationssymmetrische Verteilungen der Polarisation zuzulassen. Dies gilt besonders für Projektionsobjektive im DUV.

Gelöst wird diese Aufgabe durch ein katadioptrisches Objektiv nach Anspruch 1.

Die Erfindung geht aus von der Erkenntnis, daß die Polarisatioriseffekt an Umlenkspiegeln bei der Abbildungsleistung hochwertiger Objektive, insbesondere mikrolithographischer Projektionsobjektive, nicht unberücksichtigt bleiben können. Phasenverschiebung und Seitenversatz für gegenüber der Einfallsebene am Umlenkspiegel verschieden polarisiertes Licht sind zu berücksichtigen, da sie zu erheblichen Bildstörungen führen können.

Mindestens im Strahlengang vom letzten Objektivelement zur Bildebene ist aber - hauptsächlich bei großen numerischen Aperturen von 0,5 und darüber - eine zur optischen Achse rotationssymmetrische Polarisation (radiale, zirkulare) notwendig, da sonst die Einkopplung in den Lichtempfänger (Resist) azimutal variiert.

Zur Kompensation der Polarisationseffekte stehen windschiefe Paarungen der Spiegel und phasenkorrigierende dielektrische Schichten zur Verfügung.

An den bei katadioptrischen Systemen Korrektur- und Abbildungs-wirksam gekrümmten Spiegeln liegen regelmäßig kleine Ablenkwinkel vor, bei denen dieser Polarisations-Störeffekt geringfügig bleibt. Anders ist dies jedoch bei Umlenkspiegeln.

Den gleichen Erfindungsgedanken in verschiedenen vorteilhaften Ausformungen spiegeln die nebengeordneten Ansprüche 2 bis 5 und 11 wieder. Vorteilhafte Ausführungsformen sind Gegenstand der Unteransprüche 6 bis 10 und 12 bis 15. Diese betreffen insbesondere die Ausbildung als DUV-Mikrolithographie-Projektionsobjektiv mit Zwischenbild vom abgewandelten Schupmann-Achromat-Typ, bei dem die Erfindung besonders vorteilhaft zur Anwendung.kommt.

Eine derartige Projektionsbelichtungsanlage ist Gegenstand des Anspruches 16, vorteilhafte Weiterbildungen davon sind in den Ansprüchen 17 bis 20 wiedergegeben. Wichtig ist dabei die Freiheit in der Wahl des Polarisationszustands des Lichts im Projektionsobjektiv.

Näher erläutert wird die Erfindung anhand der Zeichnung. Diese zeigt in
- Figur 1: schematisch ein Objektiv mit windschiefen Umlenkspiegeln;
- Figur 2a, 2b: zwei Ansichten eines Prismas mit windschiefen Umlenkflächen;
- Figur 3: schematisch ein Objektiv mit Phasenkorrektur-Spiegelbeschichtung; und
- Figur 4: zeigt schematisch eine erfindungsgemäße Projektionsbelichtungsanlage.

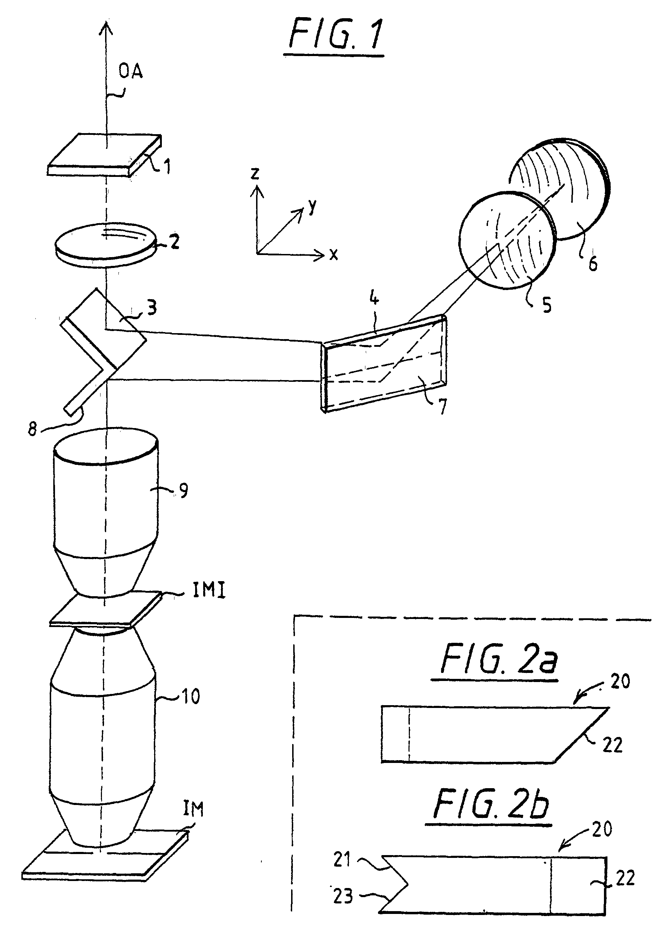

Die Zeichnung Figur 1 zeigt eine Objektebene 1, in der eine Maske (Retikel) der Mikrolithographie angeordnet werden kann, eine Linse 2, einen ersten planen Umlenkspiegel 3, einen zweiten planen Umlenkspiegel 4, eine Linsengruppe 5, einen Konkavspiegel 6, einen dritten planen Umlenkspiegel 7 - dieser kann mit dem Umlenkspiegel 4 komplanar vereinigt sein -, einen vierten planen Umlenkspiegel 8, eine zweite Linsengruppe 9, eine Zwischenbildebene IMI, eine vierte Linsengruppe 10 (refraktives Teilobjektiv) und die Bildebene IM, in der der zu belichtende Wafer mit einer Resistschicht angeordnet werden kann.

Bis auf die Umlenkspiegel 4 und 7 entspricht die Anordnung einem katadioptrischen Objektiv der oben genannten Art, z.B. der EP 0 736 789 A2.

Erfindungsgemäß sind jedoch die Umlenkspiegel 4 und 7 angeordnet, deren Einfallsebenen nicht komplanar sind mit den planen Umlenkspiegeln 3 und 8. Vorzugsweise sind die Einfallsebenen der Umlenkspiegel 4 und 7 senkrecht zu den Einfallsebenen der Umlenkspiegel 3 und 8. Das Licht durchläuft also nacheinander drei nicht komplanare, vorzugsweise zueinander senkrechte Richtungen. Durch die dementsprechenden Umlenkungen wird die oben beschriebene Kompensation polarisations-abhängiger Effekte an den Umlenkspiegeln 3, 4, 7, 8 bewirkt und das Objektiv kann mit Licht beliebiger Polarisation betrieben werden.

Vorzugsweise, zur Erleichterung der Herstellung und Justage, werden die beiden Spiegel 4 und 7 als ein gemeinsames planes Teil ausgeführt.

Die Figuren 2a und 2b zeigen Aufsicht und Seitenansicht eines Porro-Prismas 20, das mit seinen reflektierenden Flächen 21 und 23 die Umlenkspiegel 3 und 8 und mit der Fläche 22 die Umlenkspiegel 4 und 7 substituieren kann. Die reflektierenden Flächen 21, 22, 23 sind vorzugsweise mit einer Schutzschicht versehen.

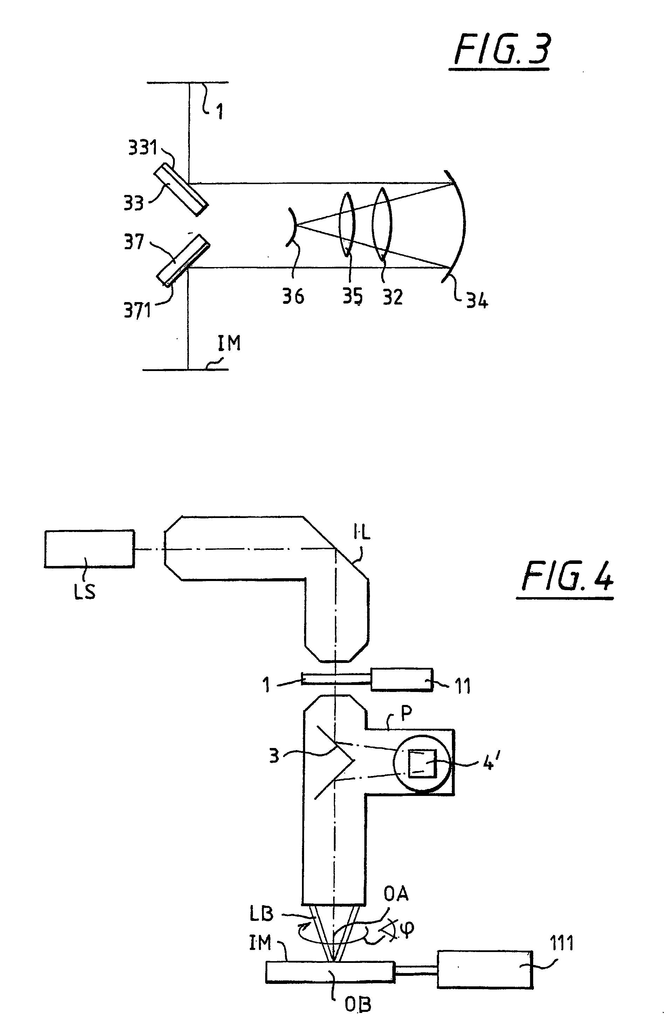

Figur 3 zeigt ein katadioptrisches Objektiv vom Offner-Typ, wie es als 1:1 Projektionsobjektiv in der Mikrolithographie eingeführt ist. Auch dieses weist zwei plane Umlenkspiegel 33, 37 auf, welche für eine praktisch vorteilhafte Anordnung von Objektebene 1 und Bildebene IM und optischem System, bestehend aus Linsengruppen 32, 35 und gekrümmten Spiegeln 34, 36, sorgen.

An sich bekannte phasenkorrigierende dielektrische dünne Schichten 331, 371 ergeben hier eine Kompensation polarisations-spezifischer Effekte bei der Reflexion an den Umlenkspiegeln 33, 37, ohne daß zusätzliche spiegelnde Elemente eingebaut werden müssen.

Diese phasenkorrigierenden Schichten sind jedoch schwierig herzustellen für große Strahldivergenzen und kleine Wellenlängen. Je nach Bedeutung dieser Parameter wird der Fachmann also die Ausführung mit zusätzlichen windschiefen Umlenkspiegeln (bzw. Porro-Prismen) nach den Figuren 1 oder 2a, 2b bevorzugen.

Figur 4 gibt einen schematischen Überblick über eine erfindungsgemäße Projektionsbelichtungsanlage. Eine Lichtquelle LS - bevorzugt ein Excimer-Laser im DUV-, eine Beleuchtungsoptik IL, ein Retikel 1 mit Halter und Justier/Scan-Einheit 11 bekannter Art werden mit einem erfindungsgemäßen Projektionsobjektiv P mit planem Umlenkspiegel 3 und Kompensationsspiegel 4' verbunden und erzeugen in der Bildebene IM auf einem Objekt OB - z.B. einem Wafer für mikroelektronische Schaltungen - ein Belichtungsmuster. Das Objekt OB ist ebenfalls verbunden mit einer Halte-, Justage- und Scaneinheit 111.

Aus dem Projektionsobjektiv P tritt das bildgebende Lichtbündel LB unter Azimutwinkeln ϕ aus. Für die Belichtung ist es vorteilhaft, wenn die Polarisation des Lichts unter jedem Azimutwinkel ϕ bezogen auf die Einfallsebene zum Objekt OB gleich ist. Dies wird mit einer erfindungsgemäßen Kompensation der Polarisationseigenschaften des Umlenkspiegels 3 - im Beispiel durch den Umlenkspiegel 4' - ermöglicht.

Die erfimdungsgemäße Anordnung eignet sich besonders für kleinste Strukturen im Submikrometer-Bereich für hochaperturige Objektive (NA > 0,5). Auch unter den dann steilen Auftreffwinkeln am Objekt werden Unregelmäßigkeiten der Lichteinkopplung vermieden.

## Patentansprüche

1. Objektiv enthaltend mindestens einen Umlenkspiegel oder Umlenkprisma (20) mit einer ersten reflektierenden Fläche (3, 21) zur Umlenkung einer optischen Achse(OA) und mit mindestens einer zweiten reflektierenden Fläche (4, 22) zur Umlenkung der optischen Achse(OA), **dadurch gekennzeichnet, daß** die zweite reflektierende Fläche der ersten reflektierenden Fläche (3, 21) derart nachgeordnet ist, daß die optische Achse (OA) mindestens drei nicht komplanare Richtungen (x, y, z) durchläuft.

2. Objektiv nach Anspruch 1, **dadurch gekennzeichnet, dass** die zweite reflektierende Fläche (4, 22) der ersten reflektierenden Fläche (3, 21) derart nachgeordnet ist, daß die optische Achse (OA) drei im wesentlichen zueinander senkrechte Richtungen (x, y, z) durchläuft.

3. Objektiv nach Anspruch 1 oder 2, **dadurch gekennzeichnet, dass** die erste reflektierende Fläche (3, 21) und die zweite reflektierende Fläche (4,22) nicht parallele Einfallsebenen aufweisen.

4. Objektiv nach Anspruch 3, **dadurch gekennzeichnet dass**, die Einfallsebenen im wesentlichen senkrecht zueinander sind.

5. Objektiv nach einem der Ansprüche 1 bis 4, **dadurch gekennzeichnet, dass** die reflektierenden Flächen (3, 4, 21, 22) plan sind.

6. Objektiv nach einem der Ansprüche 1 bis 5, **dadurch gekennzeichnet, dass** die reflektierenden Flächen (3, 4, 21, 22) derart angeordnet sind, daß die reflektierenden Flächen (3, 4, 21, 22) polarisationsunabhängig kompensiert sind.

7. Objektiv nach einem der Ansprüche 1 bis 6, **dadurch gekennzeichnet, dass** die reflektierenden Flächen mit dünnen Schichten (331) versehen sind, welche hinsichtlich Strahl-Geometrie und Phase gleiche Reflexion von in der Einfallsebene und senkrecht dazu polarisiertem Licht bewirken.

8. Objektiv nach einem der Ansprüche 1 bis 7, **dadurch gekennzeichnet, dass** das Objektiv unabhängig vom Polarisationszustand des einfallenden Lichts hinsichtlich Strahlgeometrie und Phase gleiche Eigenschaften aufweist.

9. Objektiv nach einem der Ansprüche 1 bis 8, **dadurch gekennzeichnet, dass** das Objektiv ein katadioptrisches Objektiv ist.

10. Objektiv nach einem der Ansprüche 1 bis 9, **dadurch gekennzeichnet, dass** das Objektiv ein Zwischenbild aufweist.

11. Objektiv nach einem der Ansprüche 1 bis 10, **dadurch gekennzeichnet, dass** das Objektiv vom Typ abgewandelter Schupmann-Achromat ist.

12. Objektiv nach einem der Ansprüche 1 bis 11, **dadurch gekennzeichnet, dass** das Objektiv als Projektionsobjektiv der Mikrolithographie für DUV-Licht ausgebildet ist, insbesondere für Wellenlängen von 100-250 nm.

13. Objektiv nach Anspruch 12, **dadurch gekennzeichnet, dass** das Objektiv eine bildseitige numerische Apertur größer als 0,5, vorzugsweise größer als 0,6 aufweist.

14. Objektiv nach einem der Ansprüche 1 bis 13, **dadurch gekennzeichnet, dass** polarisationspezifische Effekte bei der Spiegelung an den reflektierenden Flächen (3, 4, 21, 22) kompensiert sind.

15. Objektiv nach Anspruch 14, **dadurch gekennzeichnet, dass** ein polarisationspezifischer Seitenversatz kompensiert ist.

16. Objektiv nach Anspruch 14 oder 15 mit einem Umlenkspiegel (33), **dadurch gekennzeichnet, daß** der Umlenkspiegel (33) polarisationspezifische dünne Schichten (331) trägt.

17. Projektionsbelichtungsanlage der Mikrolithographie mit einem Projektionsobjektiv (P), welches nach mindestens einem der Ansprüche 1-16 ausgeführt ist.

18. Projektionsbelichtungsanlage nach Anspruch 17, **dadurch gekennzeichnet, daß** Licht im Projektionsobjektiv (P) nicht linear polarisiert ist und der Polarisationszustand der aus dem Projektionsobjektiv (P) auf dem Bildfeld (IM) austretenden Lichtbündel (LB) für alle Azimutwinkel (ϕ) bezogen auf die Einfallsebene gleich ist.

19. Projektionsbelichtungsanlage nach Anspruch 18, **dadurch gekennzeichnet, daß** das Licht im Projektionsobjektiv (P) unpolarisiert ist.

20. Projektionsbelichtungsanlage nach Anspruch 18, **dadurch gekennzeichnet, daß** das Licht im Projektionsobjektiv (P) radial polarisiert ist.

21. Projektionsbelichtungsanlage nach Anspruch 18, **dadurch gekennzeichnet, daß** das Licht im Projektionsobjektiv (P) zirkular polarisiert ist.

## Claims

1. Objective containing at least one deflecting mirror or deflecting prism (20), having a first reflecting surface (3, 21) for deflecting an optical axis (OA), and having at least one second reflecting surface (4, 22) for deflecting the optical axis (OA), **characterized in that** the second reflecting surface is arranged downstream of the first reflecting surface (3, 21) in such a way that the optical axis (OA) traverses at least three non-coplanar directions (x, y, z).

2. Objective according to Claim 1, **characterized in that** the second reflecting surface (4, 22) is arranged downstream of the first reflecting surface (3, 21) in such a way that the optical axis (OA) traverses three substantially mutually perpendicular directions (x, y, z).

3. Objective according to Claim 1 or 2, **characterized in that** the first reflecting surface (3, 21) and the second reflecting surface (4, 22) have non-parallel planes of incidence.

4. Objective according to Claim 3, **characterized in that** the planes of incidence are substantially mutually perpendicular.

5. Objective according to one of Claims 1 to 4,
**characterized in that** the reflecting surfaces (3, 4, 21, 22) are plane.

6. Objective according to one of Claims 1 to 5, **characterized in that** the reflecting surfaces (3, 4, 21, 22) are arranged in such a way that the reflecting surfaces (3, 4, 21, 22) are compensated independently of polarization.

7. Objective according to one of Claims 1 to 6, **characterized in that** the reflecting surfaces are provided with thin layers (331) which cause light polarized in the plane of incidence and perpendicular thereto to be reflected identically with regard to beam geometry and phase.

8. Objective according to one of Claims 1 to 7, **characterized in that** the objective has identical properties with regard to beam geometry and phase independently of the state of polarization of the incident light.

9. Objective according to one of Claims 1 to 8, **characterized in that** the objective is a catadioptric objective.

10. Objective according to one of Claims 1 to 9, **characterized in that** the objective has an intermediate image.

11. Objective according to one of Claims 1 to 10, **characterized in that** the objective is of the type of a modified Schupmann achromat.

12. Objective according to one of Claims 1 to 11, **characterized in that** the objective is designed as a microlithography projection objective for DUV light, in particular for wavelengths of 100-250 nm.

13. Objective according to Claim 12, **characterized in that** the objective has an image-side numerical aperture of greater than 0.5, preferably of greater than 0.6.

14. Objective according to one of Claims 1 to 13, **characterized in that** polarization-specific effects are compensated during reflection at the reflecting surfaces (3, 4, 21, 22).

15. Objective according to Claim 14, **characterized in that** a polarization-specific lateral offset is compensated.

16. Objective according to Claim 14 or 15 with a deflecting mirror (33), **characterized in that** the deflecting mirror (33) bears polarization-specific thin layers (331).

17. Microlithography projection exposure machine having a projection objective (P) which is designed according to at least one of Claims 1-16.

18. Projection exposure machine according to Claim 17, **characterized in that** light in the projection objective (P) is not linearly polarized, and the state of polarization of the light bundle (LB) emerging from the projection objective (P) on the image field (IM) is identical for all azimuth angles (ϕ) referred to the plane of incidence.

19. Projection exposure machine according to Claim 18, **characterized in that** the light in the projection objective (P) is unpolarized.

20. Projection exposure machine according to Claim 18, **characterized in that** the light in the projection objective (P) is radially polarized.

21. Projection exposure machine according to Claim 18,
**characterized in that** the light in the projection objective (P) is circularly polarized.

## Revendications

1. Objectif comprenant au moins un miroir de déviation ou un prisme de déviation (20) avec une première surface réfléchissante (3, 21) pour la déviation d'un axe optique (OA) et avec au moins une deuxième surface réfléchissante (4, 22) pour la déviation de l'axe optique (OA), **caractérisé en ce que** la deuxième surface réfléchissante est placée derrière la première surface réfléchissante (3, 21) de telle sorte que l'axe l'optique (OA) passe par au moins trois directions (x, y, z) non coplanaires.

2. Objectif selon la revendication 1, **caractérisé en ce que** la deuxième surface réfléchissante (4, 22) est placée derrière la première surface réfléchissante (3, 21) de telle sorte que l'axe l'optique (OA) passe par trois directions (x, y, z) essentiellement mutuellement orthogonales.

3. Objectif selon la revendication 1 ou 2, **caractérisé en ce que** la première surface réfléchissante (3, 21) et la deuxième surface réfléchissante (4, 22) ne présentent pas de plans d'incidence parallèles.

4. Objectif selon la revendication 3, **caractérisé en ce que** les plans d'incidence sont essentiellement mutuellement orthogonaux.

5. Objectif selon une des revendications 1 à 4, **caractérisé en ce que** les surfaces réfléchissantes (3, 4, 21, 22) sont planes.

6. Objectif selon une des revendications 1 à 5, **caractérisé en ce que** les surfaces réfléchissantes (3, 4, 21, 22) sont disposées de telle sorte que les surfaces réfléchissantes (3, 4, 21, 22) sont compensées de manière indépendante de la polarisation.

7. Objectif selon une des revendications 1 à 6, **caractérisé en ce que** les surfaces réfléchissantes sont revêtues de couches minces (331) qui, du point de vue de la géométrie et de la phase des rayons, entraînent une même réflexion de la lumière polarisée dans le plan d'incidence et dans le plan orthogonal.

8. Objectif selon une des revendications 1 à 7, **caractérisé en ce que**, du point de vue de la géométrie et de la phase des rayons, l'objectif présente les mêmes caractéristiques indépendamment de l'état de polarisation de la lumière incidente.

9. Objectif selon une des revendications 1 à 8, **caractérisé en ce que** l'objectif est un objectif catadioptrique.

10. Objectif selon une des revendications 1 à 9, **caractérisé en ce que** l'objectif présente une image intermédiaire.

11. Objectif selon une des revendications 1 à 10, **caractérisé en ce que** l'objectif est de type variante d'Achromat-Schupmann.

12. Objectif selon une des revendications 1 à 11, **caractérisé en ce que** l'objectif est développé sous la forme d'un objectif de projection de microlithographie pour lumière DUV, en particulier pour des longueurs d'ondes de 100 - 250 nm.

13. Objectif selon la revendication 12, **caractérisé en ce que** l'objectif présente du côté de l'image, une ouverture numérique supérieure à 0,5, de préférence supérieure à 0,6.

14. Objectif selon une des revendications 1 à 13, **caractérisé en ce que** les effets spécifiques à la polarisation sont compensés par la réflexion sur les surfaces réfléchissantes (3, 4, 21, 22).

15. Objectif selon la revendication 14, **caractérisé en ce qu'**un décalage latéral spécifique à la polarisation est compensé.

16. Objectif selon la revendication 14 ou 15 avec un miroir de déviation (33), **caractérisé en ce que** le miroir de déviation (33) est revêtu de couches minces (331) spécifiques à la polarisation.

17. Dispositif d'éclairage de projection de microlithographie avec un objectif de projection (P) qui est réalisé selon au moins une des revendications 1 à 16.

18. Dispositif d'éclairage de projection selon la revendication 17, **caractérisé en ce que** la lumière n'est pas polarisée linéairement dans l'objectif de projection (P) et **en ce que** l'état de polarisation du faisceau de lumière (LB) sortant de l'objectif de projection (P) en direction du champ de l'image (IM) est le même en ce qui concerne le plan d'incidence pour tous les angles azimutaux (ϕ).

19. Dispositif d'éclairage de projection selon la revendication 18, **caractérisé en ce que** la lumière n'est pas polarisée dans l'objectif de projection (P).

20. Dispositif d'éclairage de projection selon la revendication 18, **caractérisé en ce que** la lumière est polarisée radialement dans l'objectif de projection (P).

21. Dispositif d'éclairage de projection selon la revendication 18, **caractérisé en ce que** la lumière est polarisée circulairement dans l'objectif de projection (P) .
